# EUROPEAN PATENT APPLICATION

(11) **EP 3 978 659 A1**
(43) Date of publication of application: **06.04.2022**
(21) Application number: 20814676.1
(22) Date of filing: 01.05.2020
(51) Int. Cl.: C30B 29/38, C23C 16/458, C30B 25/12, C30B 25/18, H01L 21/205

(54) **METHOD FOR MANUFACTURING GROUP III COMPOUND SUBSTRATE, AND GROUP III COMPOUND SUBSTRATE**

(30) Priority: 27.05.2019 JP 2019098738
(71) Applicant: SHIN-ETSU CHEMICAL CO., LTD., Tokyo 100-0004 (JP)
(72) Inventor: KUBOTA, Yoshihiro, Annaka-shi, Gunma 379-0195 (JP); NAGATA, Kazutoshi, Annaka-shi, Gunma 379-0195 (JP)
(74) Representative: Vossius & Partner Patentanwälte Rechtsanwälte mbB
(86) International application number: PCT/JP2020/018471
(87) International publication number: WO 2020/241184

(57) **Abstract**

The group III compound substrate manufacturing method of the present invention is a method for manufacturing a group III compound substrate by growing a group III compound crystal (1) by vapor phase epitaxy on a seed crystal (3) placed and fixed on a susceptor (2), the method comprising using a cleavable and separable material for at least one of the susceptor (2) and the seed crystal (3). A group III compound substrate manufactured by the group III compound substrate manufacturing method of the present invention is also provided. The present invention can provide the group III compound substrate manufacturing method which can manufacture a large-sized GaN crystal substrate of higher quality at a low cost while taking advantage of the high film forming rate of the vapor phase epitaxy method, and can provide a substrate manufactured by the method.

## Description

### Technical Field

The present invention relates to a method for manufacturing a high-quality group III compound substrate, such as an AlN, Ga₂O₃ or GaN substrate, and to the substrate, and in particular to a GaN crystal substrate.

### Background Art

A substrate of a group III compound, such as crystalline AlN, Ga₂O₃ or GaN, has a wide band gap, exhibits extremely short-wavelength luminescence, has high electric strength, and has excellent high-frequency properties. A group III compound substrate is therefore expected to be applied in devices such as a laser, a Schottky diode, a power device, and a high-frequency device. At present, however, it is difficult to grow a high-quality, large -diameter crystal of such a group III compound, which limits the application of a group III compound substrate.

For example, in the case of a GaN substrate, a bulk GaN substrate, obtained through the growth of a GaN crystal in a liquid such as liquid ammonia or a Na flux, is generally of relatively high quality. However, it is difficult for such a method to produce a large-diameter GaN crystal. On the other hand, a metalorganic chemical vapor deposition method (MOCVD method) or a hydride vapor phase epitaxy method (HVPE method, THVPE method, or the like), which involves vapor phase heteroepitaxial growth of a GaN crystal on a substrate such as a sapphire substrate, a GaAs substrate or an AlN substrate, can produce a large-diameter GaN film. However, when the thickness of a GaN film is increased in the heteroepitaxial growth method in order to obtain a high-quality substrate, a lattice defect, warpage and cracking are likely to occur.

For example, non-patent document 1 describes a method which involves attaching a plurality of small-diameter GaN substrates, which have been produced by the Na flux method, to a pyrolytic graphite (PG) susceptor in a honeycomb pattern, and growing a GaN crystal by the HVPE method on the GaN substrates as a seed substrate to obtain a large-diameter GaN substrate.

Non-patent document 2 describes a method which involves epitaxially growing a GaN crystal by the MOVPE (metalorganic vapor phase epitaxy) method on a SCAM (ScAlMgO₄) (0001) substrate as a seed crystal.

Patent document 1 describes a method which involves epitaxially growing a GaN crystal on a sapphire substrate, cutting the crystal into honeycomb pieces and attaching them to a susceptor made of, for example, PG with an adhesive, composed mainly of a heat-resistant ceramic and an inorganic polymer, to prepare a seed crystal, and performing a HVPE process to increase the size and the thickness of the GaN crystal.

### Citation List

### Patent Literature

Patent document 1: Japanese Patent No. 6203460

### Non-Patent Literature

Non-patent document 1: Phys. Status Solidi B 254, No.8, 1600671 (2017)
Non-patent document 2: Phys. Status Solidi A 214, No.9, 1600754 (2017)

### Summary of Invention

### Technical Problem

The above-described prior art techniques further have the following two common problems. After the growth of a GaN crystal, the GaN crystal is cooled, and separated and recovered from a seed crystal. Since the grown GaN crystal and the seed crystal are strongly bonded to each other, it is difficult to obtain the target GaN crystal at a high yield and to recover the expensive seed crystal. If the grown GaN crystal is forcibly separated and recovered from the seed crystal such as sapphire or GaN, the grown GaN crystal is likely to be damaged upon the separation or upon its handling in a later step or processing. In addition, the seed crystal strongly adheres not only to the grown GaN crystal but to a susceptor as well. A strong thermal stress will therefore be applied to the grown GaN crystal, causing warpage or cracking of the GaN crystal.

The present invention has been made in view of the above situation. It is therefore an object of the present invention to provide a manufacturing method which can grow a high-quality, large-diameter and thick group III compound substrate, such as an AlN or GaN crystal, and to provide a group III compound substrate, especially a GaN substrate, obtained by the method.

### Solution to Problem

In order to achieve the above object, the present invention provides the following methods for manufacturing a group III compound substrate, and the substrate.
(1) A method for manufacturing a group III compound substrate by growing a group III compound crystal by vapor phase epitaxy on a seed crystal placed and fixed on a susceptor, the method comprising using a cleavable and separable material for at least one of the susceptor and the seed crystal.
(2) The method for manufacturing a group III compound substrate as described in (1) above, wherein the susceptor, at least in its surface on which the seed crystal is placed, is composed of the cleavable and separable material, and wherein the cleavable and separable material is pyrolytic boron nitride (PBN).
(3) The method for manufacturing a group III compound substrate as described in (1) or (2) above, wherein the cleavable and separable material is a composite of pyrolytic boron nitride (PBN) and carbon.
(4) The method for manufacturing a group III compound substrate as described in any one of (1) to (3) above, wherein the seed crystal is composed of the cleavable and separable material, and wherein the cleavable and separable material is a SCAM (ScAlMgO₄) crystal.
(5) The method for manufacturing a group III compound substrate as described in any one of (1) to (4) above, comprising a first crystal growth step of growing the group III compound crystal on the seed crystal at a first crystallization rate, and a second crystal growth step, performed after the first crystal growth step, of growing the group III compound crystal on the seed crystal at a second crystallization rate which is lower than the first crystallization rate.
(6) The method for manufacturing a group III compound substrate as described in (5) above, comprising a third crystal growth step, performed between the first crystal growth step and the second crystal growth step, of growing the group III compound crystal on the seed crystal at a third crystallization rate, wherein in the third crystal growth step, the third crystallization rate changes from the first crystallization rate to the second crystallization rate in a stepwise and/or continuous manner.
(7) The method for manufacturing a group III compound substrate as described in any one of (1) to (6) above, wherein the group III compound is gallium nitride (GaN).
(8) A group III compound substrate manufactured by the method for manufacturing a group III compound substrate as described in any one of (1) to (7) above.

### Advantageous Effects of Invention

According to the present invention, while taking advantage of the high film forming rate of the vapor phase epitaxy method, a large-sized group III compound substrate of higher quality can be obtained at a low cost. In particular, a very thick, variation-free, large-diameter group III compound substrate can be manufactured. Thus, a low-cost, large-diameter group III compound substrate having excellent crystal properties can be easily obtained.

### Brief Description of Drawings

[FIG. 1] FIG. 1 is a schematic diagram illustrating a group III compound substrate manufacturing method according to an embodiment of the present invention.
[FIG. 2] FIG. 2 is a schematic diagram illustrating an example of a group III compound substrate manufacturing method according to an embodiment of the present invention.

### Description of Embodiments

The group III compound substrate manufacturing method of the present invention is a method for manufacturing a group III compound substrate by growing a group III compound crystal by vapor phase epitaxy on a seed crystal placed and fixed on a susceptor, the method comprising using a cleavable and separable material for at least one of the susceptor and the seed crystal. For example, the susceptor may be, in whole or in part, composed of the cleavable and separable material. The seed crystal may be, in whole or in part, composed of the cleavable and separable material. Embodiments of the method for manufacturing a group III compound substrate, especially a GaN substrate, according to the present invention, and embodiments of such a substrate will now be described.

The manufacturing method of the present invention is effective for a group III compound such as AlN, Ga₂O₃ or GaN, and is especially suited for the growth of a GaN crystal. The present method particularly relates to a vapor phase epitaxy method, especially a hydride vapor phase epitaxy method (HVPE method, THVPE method, or the like), which is suitable for the production of a thick large-diameter group III compound substrate because of the high crystal growth rate of a group III compound.

The conventional hydride vapor phase epitaxy method (HVPE method, THVPE method, or the like) has the following problems. After the growth of a GaN crystal, the GaN crystal is cooled, and separated and recovered from a seed crystal such sapphire or GaN. Since the grown GaN crystal and the seed crystal are strongly bonded to each other, it is very difficult to obtain the target GaN crystal at a high yield without damage to the GaN crystal and to recover the expensive seed crystal. If the grown GaN crystal is forcibly separated and recovered from the seed crystal such as sapphire or GaN, an excessive force is likely to be applied to the grown GaN crystal, resulting in cracking or damage to the valuable GaN crystal. In addition, the seed crystal strongly adheres not only to the grown GaN crystal but to a susceptor structure as well. Therefore, after the reaction and the subsequent cooling of the GaN crystal, a strong thermal stress is applied to the GaN crystal, causing deterioration of properties of the GaN crystal and warpage or cracking of the GaN crystal. Such a phenomenon is prominent especially in the case of growing a thick large-diameter crystal, and thus significantly hampers enhancement of properties of a GaN substrate and a reduction in the cost of the GaN substrate.

The present inventors, through their intensive studies, have solved the above problem by using a cleavable and separable material for one or both of a seed crystal and a susceptor for placing the seed crystal thereon. When the cleavable and separable material is used for the seed crystal, the seed crystal can be easily separated from a cleaved surface of the seed crystal upon the separation of a grown GaN crystal. Thus, the grown GaN crystal and the seed crystal can be easily recovered. When the cleavable and separable material is used for the susceptor, the susceptor can be easily separated from a cleaved surface of the susceptor upon the separation of a grown GaN crystal. Thus, the grown GaN crystal and the seed crystal can be easily recovered.

Therefore, while taking advantage of the high film forming rate of the vapor phase epitaxy method, a large-sized GaN crystal substrate of higher quality can be obtained at a low cost. In particular, a very thick, variation-free, large-diameter GaN crystal substrate can be manufactured. Thus, a low-cost, large-diameter GaN substrate having excellent crystal properties can be easily obtained.

The susceptor, at least in its surface on which the seed crystal is placed, may be composed of the cleavable and separable material. Thus, the susceptor need not be entirely composed of the cleavable and separable material.

The cleavable material to be used for the susceptor is preferably a layered material. When a layered material is used for the susceptor, the susceptor can be easily separated between net planes in the layer structure of the layered material upon the separation of a grown GaN crystal. Thus, the grown GaN crystal and the seed crystal can be easily recovered. Furthermore, when a layered material is used for the susceptor, a thermal stress, generated due to adhesion between a grown GaN crystal and the susceptor, can sometimes be absorbed between layers, and can sometimes be reduced by delamination.

By using the cleavable and separable material for at least one of the susceptor and the seed crystal, even a thick large-diameter GaN crystal can be obtained at a high yield without the occurrence of warpage or cracking, which has heretofore been difficult. Furthermore, it becomes possible to easily recover the expensive seed crystal, and to reuse the seed crystal.

The "cleavable and separable material" herein refers to a material which cleaves on a mechanical impact at such a level as not to crack or scratch a group III compound substrate or a seed crystal, or a material which cleaves on a thermal stress produced by a difference in the thermal expansion coefficient between a group III compound substrate and a seed crystal.

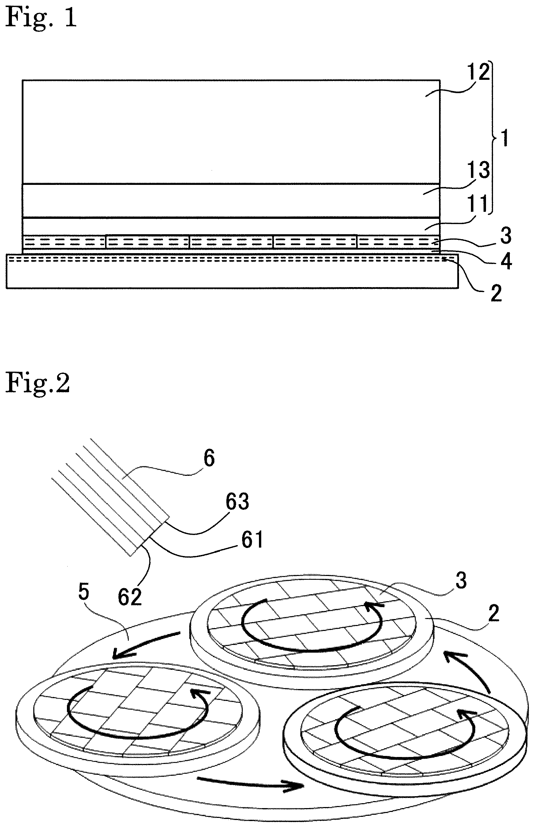

Preferably, a base (handle) substrate portion 11 of GaN is first produced at a relatively high crystal growth rate, and then a thick GaN crystal body portion 12 is produced at a low crystal growth rate (see FIG. 1). The base (handle) substrate portion 11 of GaN functions as (i) a barrier layer against impurity diffusion from a seed crystal 3 or a susceptor 2, (ii) a "sacrificial layer" which, based on the fact that the thicker a crystal is grown, the fewer are crystal defects in the top portion of the crystal, reduces crystal defects in the target GaN crystal body portion 12, (iii) a "protective layer" for protecting the GaN crystal body portion 12 from mechanical damage, e.g. upon the separation of the grown crystal or during a later processing step, or (iv) a handle substrate to be used upon an operation or transportation of the GaN crystal. By thus producing the target GaN crystal body portion 12 through the low-rate crystal growth of GaN, deterioration of a property, such as a lattice defect, and a variation of other properties can be favorably prevented.

From the viewpoints of price, corrosion resistance to reaction gases (GaCl, GaCl₃, NH₃), the entry of impurities, etc., the cleavable and separable material for the susceptor is preferably pyrolytic boron nitride (PBN) which is a high-purity layered compound having corrosion resistance to reaction gases. PBN whose interlayer bonding strength has been intentionally reduced and which is therefore easy to delaminate, or a composite of such PBN and carbon is more preferred in view of the cost (large size, high strength). Among boron nitrides, hexagonal boron nitride is a layered compound.

A method described in Japanese Patent Publication No. H04-79992, for example, can be used to produce a PBN/carbon composite by forming a PBN film on the surface of a carbon substrate. A PBN layer in which the bonding strength between planes in a layer structure, in which atoms are bonded planarly, is reduced can be formed by increasing/decreasing the pressure in a chemical vapor deposition furnace in a pulsed manner during the formation of the PBN film in the furnace. By appropriately inserting such PBN layers with reduced interlayer bonding strength during the formation of the PBN film, it is possible to form the PBN film which is easy to delaminate.

A SCAM (ScAlMgO₄) crystal is preferably used as the cleavable and separable material for the seed crystal from the viewpoints of closeness to the lattice constant and the thermal expansion coefficient of a GaN crystal, resistance to reaction gases, relatively low price, and the ease of separation and recovery from a grown GaN crystal. The use of a single substrate of a cleavable SCAM (ScAlM₉O₄) crystal, or a substrate composed of a plurality of such SCAM substrates bonded and aligned together in a crystal direction is particularly preferred. In view of corrosion resistance to reaction gases (GaCl, GaCl₃, NH₃), the entry of impurities, etc., a substrate surface may be coated with SiO₂, AlN, or the like.

In the present invention, when the susceptor for placing a seed crystal thereon is made of a cleavable and separable material, the seed crystal may not be a cleavable and separable material. In this case, a GaN substrate or the like, produced by a method selected from the MOCVD method, the Na flux method and the liquid ammonia method, may be used for the seed substrate.

In the present invention, when the seed crystal is a cleavable and separable material, the susceptor may not be made of a cleavable and separable material. In this case, a GaN substrate itself, pyrolytic graphite (PG), a ceramic such as corundum, etc. may be used for the susceptor. PG is a cleavable layered material; however, because of the strong bond between net planes in the layer structure, it does not separate easily.

In the present invention, for the reasons described above, it is preferred that the base (handle) substrate portion 11 of GaN be first produced at a relatively high crystal growth rate, and then the thickness of the GaN crystal body portion 12 be increased at a relatively low crystal growth rate. Further, from economical and efficiency aspects, and because of the capability to prevent the generation of a stress in a grown GaN crystal and to enhance properties of the GaN crystal, it is especially preferred that the crystal growth rate be changed (decreased) from the high rate to the low rate in a stepwise and/or continuous manner (see the crystal growth rate transition portion 13 of FIG. 1).

### Examples

Non-limiting working examples according to the present invention will now be described.

The following examples illustrate the present invention in greater detail and are not intended to limit the scope of the invention.

### [Example 1]

A stainless-steel reactor (having a very thin thermal-sprayed coating of zirconia on the inner surface) having an inner diameter of 1500 mm and a height of 1800 mm was provided. The reactor had a water-cooling jacket and an exhaust port, internally had a mat-like heat insulating material of alumina and had, inside the insulating material, a heating device (inner diameter 1000 mm x height 1300 mm) including a rod-like, cylindrical SiC heater, and gas supply tubes (see symbol 6 of FIG. 2) (central tube 61, inner diameter 30 mm; second tube 62, inner diameter 40 mm; outermost tube 63, inner diameter 50 mm, the tubes made of the same material as that of the reactor). On the other hand, a susceptor revolving jig (see symbol 5 of FIG. 2) of PBN-coated graphite having a diameter of 520 mm, on which three susceptors (see symbol 2 of FIG. 2) each having a diameter of 170 mm and made of PBN (produced by a method which involves changing the pressure in a furnace during the formation of the PBN) which is easy to delaminate were placed at 120-degree intervals, was provided in the reactor. Tile-shaped crystals as a seed substrate (see symbol 3 of FIG. 2), cut from a 2-inch SCAM crystal, were bonded to the surface of each susceptor into a disk-like shape having a diameter of 6 inches using an alumina adhesive (see symbol 4 of FIG. 1) applied to the back surfaces of the tile-shaped crystals. Thereafter, while heating the susceptors 2 at 1380°C with the heater, the susceptor revolving jig 5 was rotated at 10 rpm to revolve the susceptors 2, and the three susceptors 2 were each rotated at 30 rpm by means of revolving gears. After confirming the stability of the temperature and the rotations, into the reactor, GaCl₃ gas was supplied from the central tube 61 of the triplet tube, NH₃ gas was supplied from the outermost tube 63, and N₂ gas was supplied from the tube 62 between the central tube and the outermost tube to initiate a THVPE reaction.

The reaction was first carried out for 1 hour at a high crystal growth rate of about 300 µm/h (see symbol 11 of FIG. 1), and then the supply of the reaction gases was gradually decreased over 2 hours to adjust the crystal growth rate finally to about 100 µm/h (see symbol 13 of FIG. 1). Subsequently, the reaction was caried out at a low rate for 45 hours (see symbol 12 of FIG. 1).

After cooling the resulting GaN crystal, the GaN crystal was easily separated from the SCAM seed crystal thanks to the cleavability of the SCAM seed crystal. The SCAM seed crystal was recovered for reuse. A thermal stress was absorbed by delamination in the layered PBN susceptor, and therefore almost no warping occurred in the separated GaN crystal. Accordingly, the resulting GaN crystal could be easily machined directly by cylindrical grinding into an original substrate having a diameter of 6 inches and a thickness of 5 mm, and composed of a high-rate reaction portion, a rate transition portion and a low-rate reaction portion.

The surface of the low-rate reaction portion of the original substrate was appropriately sliced, and the sliced piece was polished to obtain a flat and smooth GaN substrate having a thickness of 625 µm. For reaction analysis, the following analysis was performed on the GaN substrate product of the low-rate reaction portion and on the GaN substrate containing the high-rate reaction portion (see symbol 11 of FIG. 1). The high-rate reaction portion functions as a handle substrate upon processing of the GaN substrate, as a "protective layer" for reducing mechanical damage, as a "barrier layer" for preventing contamination with impurities, e.g., from the adhesive, and as a "sacrificial layer" for reducing crystal defects.

For the GaN substrate processed from the low-rate reaction portion (see symbol 12 of FIG. 1), the FWHM (Full Width at Half Maximum) of the X-ray rocking curve for the (100) plane was measured. As a result, for measured values at three arbitrary points on the plane, the average was 31 arcsec and the variation was 3 arcsec. This indicates good crystallinity of the GaN substrate. On the other hand, the average FWHM was 448 arcsec and the variation was 84 arcsec for the GaN substrate containing the high-rate reaction portion (see symbol 11 of FIG. 1). Further, the surface of each of these substrates was subjected to a chemical analysis. As a result, metal contamination of the GaN substrate of the low-rate reaction portion 12 was found to be below the detection limit, while entry or contamination of a slight amount of metals such as Mg, Al, Si, Fe, etc., which were considered to have come from the seed crystal and the alumina adhesive used, was detected on the lower side (seed crystal side, susceptor side) of the GaN substrate containing the high-rate reaction portion 11.

Further, an observation of stacking fault with a monochrome cathode luminescence image revealed almost no fault in a surface layer of the GaN substrate product. On the other hand, stacking faults were found in the GaN substrate containing the high-rate reaction portion 11, especially in the high-rate reaction portion 11. This indicates that the high-rate reaction portion 11 functions as an impurity trapping layer or a defect sacrifice layer. The above results demonstrate that the GaN substrate product is a good, uniform, warpage-free GaN crystal substrate substantially free of variation. The results of Example 1 indicate a significant synergistic effect produced by (1) the use of a cleavable and separable and/or layered material for one or both of a seed crystal and a susceptor structure for placing the seed crystal thereon, and (2) the first formation of the base (handle) substrate portion 11 of GaN at a relatively high crystal growth rate, and the subsequent formation of the thick GaN crystal body portion 12 at a low crystal growth rate.

### [Comparative Example]

A crystal growth reaction was carried out in the same manner as in Example 1 except for changing the seed crystal from the SCAM crystal to a 2-inch GaN substrate produced by the Na flux method and which was not cleavable and separable, and changing the susceptor to a corundum (ceramic) susceptor which was not cleavable and separable. After the THVPE reaction and the subsequent cooling, the GaN crystal was found to be fusion-bonded to the susceptor. Therefore, when the grown GaN crystal and the valuable seed substrate were tried to be recovered, they broke into pieces and could not be recovered.

### [Example 2]

A crystal growth reaction was caried out in the same manner as in Example 1 except for changing the SCAM seed substrate to a 2-inch GaN substrate produced by the Na flux method and which was not cleavable and separable, and changing the reaction gas from GaCl₃ gas to GaCl gas to change the THVPE method to the HVPE method. The reaction was performed at the same linear velocity in terms of Ga as in Example 1. After cooling, the resulting GaN crystal was integrated with the seed crystal, and could be easily separated from the layered PBN susceptor. A thermal stress of concern upon cooling of the GaN crystal was absorbed by delamination; therefore, no cracking and almost no warping occurred in the GaN crystal. As in Example 1, for the GaN substrate product, the FWHM (Full Width at Half Maximum) of the X-ray rocking curve for the (100) plane was measured. As a result, for measured values at three arbitrary points on the plane, the average was 25 arcsec and the variation was 3 arcsec. The amount of metal impurities analyzed was below the detection limit. Further, an observation of stacking fault with a monochrome cathode luminescence image revealed almost no fault in a surface layer of the GaN crystal. The above measurements and observation demonstrate that the resulting GaN crystal is a good uniform crystal substrate substantially free of variation.

### [Example 3]

A crystal growth reaction was caried out in the same manner as in Example 1 except that the crystal growth reaction was carried out for 50 hours at a low rate of about 100 µm/h from the start, and that pyrolytic graphite (PG), which is cleavable but is difficult to separate, was used for the susceptor. The resulting GaN crystal could be easily separated from the SCAM seed crystal and the PG susceptor. The SCAM seed crystal could be recovered and was reusable. A thermal stress in the GaN crystal was not sufficiently absorbed by the poor delamination in the layered PG susceptor, whereby a few millimeters of warpage occurred in the GaN crystal, though no cracking occurred. The GaN crystal was machined by cylindrical grinding into a 6-inch substrate while making some correction.

### Reference Signs List

1 GaN substrate
2 susceptor
3 seed crystal
4 adhesive
5 susceptor revolving jig
6 gas supply tubes
11 base (handle) substrate portion
12 GaN crystal body portion
13 crystal growth rate transition portion

## Claims

1. A method for manufacturing a group III compound substrate by growing a group III compound crystal by vapor phase epitaxy on a seed crystal placed and fixed on a susceptor, the method comprising using a cleavable and separable material for at least one of the susceptor and the seed crystal.

2. The method for manufacturing a group III compound substrate according to claim 1, wherein the susceptor, at least in its surface on which the seed crystal is placed, is composed of the cleavable and separable material, and wherein the cleavable and separable material is pyrolytic boron nitride (PBN).

3. The method for manufacturing a group III compound substrate according to claim 1 or 2, wherein the cleavable and separable material is a composite of pyrolytic boron nitride (PBN) and carbon.

4. The method for manufacturing a group III compound substrate according to any one of claims 1 to 3, wherein the seed crystal is composed of the cleavable and separable material, and wherein the cleavable and separable material is a SCAM (ScAlMgO₄) crystal.

5. The method for manufacturing a group III compound substrate according to any one of claims 1 to 4, comprising a first crystal growth step of growing the group III compound crystal on the seed crystal at a first crystallization rate, and a second crystal growth step, performed after the first crystal growth step, of growing the group III compound crystal on the seed crystal at a second crystallization rate which is lower than the first crystallization rate.

6. The method for manufacturing a group III compound substrate according to claim 5, comprising a third crystal growth step, performed between the first crystal growth step and the second crystal growth step, of growing the group III compound crystal on the seed crystal at a third crystallization rate, wherein in the third crystal growth step, the third crystallization rate changes from the first crystallization rate to the second crystallization rate in a stepwise and/or continuous manner.

7. The method for manufacturing a group III compound substrate according to any one of claims 1 to 6, wherein the group III compound is gallium nitride (GaN).

8. A group III compound substrate manufactured by the method for manufacturing a group III compound substrate according to any one of claims 1 to 7.
